# FASCICULE DE BREVET EUROPEEN

(11) **EP 0 786 817 B1**
(45) Date de publication et mention de la délivrance du brevet: **22.09.2004**
(21) Numéro de dépôt: 97410010.9
(22) Date de dépôt: 24.01.1997
(51) Int. Cl.: H01L 29/735, H01L 29/74, H01L 27/08

(54) **Composants latéraux dans un dispositif semiconducteur de puissance**
Seitenbauteile in einer Leistungshalbleiteranordnung
Side components in a power semi-conductor device

(30) Priorité: 26.01.1996 FR 9601179
(43) Date de publication de la demande: 30.07.1997
(73) Titulaire: STMicroelectronics S.A., 92120 Montrouge (FR)
(72) Inventeur: Bernier, Eric, 37390 Mettray (FR); Simonnet, Jean-Michel, 37000 Tours (FR)
(74) Mandataire: de Beaumont, Michel

(56) Documents cités:
- FR-A- 1 418 640
- US-A- 4 982 245
- IEEE TRANSACTIONS ON ELECTRON DEVICES, vol. 24, no. 3, Mars 1977, NEW YORK US, pages 205-214, XP002016212 K.N. BHAT AND M.K. ACHUTHAN: "Current-gain Enhancement in Lateral p-n-p Transistors by Optimized Gap in the n+ Buried Layer"
- PATENT ABSTRACTS OF JAPAN vol. 002, no. 029 (E-017), 23 Février 1978 & JP 52 150984 A (MITSUBISHI ELECTRIC CORP), 15 Décembre 1977,
- PATENT ABSTRACTS OF JAPAN vol. 001, no. 019 (E-004), 24 Mars 1977 & JP 51 116685 A (FUJITSU LTD), 14 Octobre 1976,

## Description

La présente invention concerne le domaine des dispositifs semiconducteurs de puissance monolithiques et plus particulièrement l'optimisation de composants latéraux dans de tels dispositifs semiconducteurs de puissance.

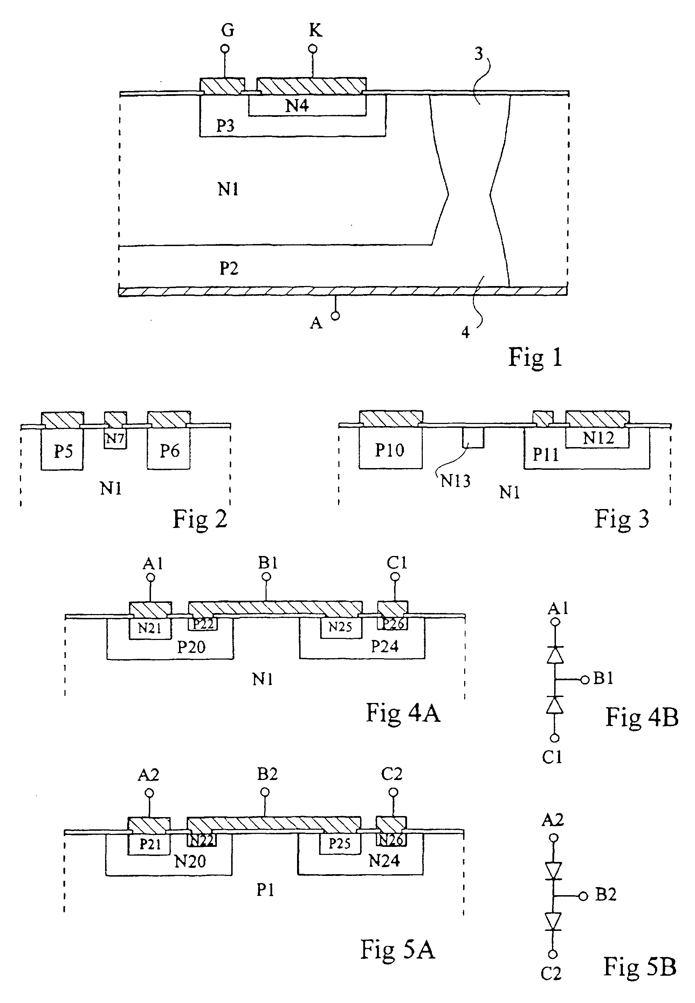

De façon générale, les dispositifs semiconducteurs destinés à laisser passer de forts courants et à supporter des tensions élevées sont réalisés verticalement dans des plaquettes de silicium. Un exemple particulier est illustré en figure 1 qui est une vue en coupe schématique d'un thyristor. Ce composant est réalisé à partir d'une plaquette de silicium d'une épaisseur de 0,2 à 0,4 mn constituée d'un monocristal semiconducteur très faiblement dopé (couramment 10¹⁴ à 10¹⁶ atomes/cm³). Une électrode principale du thyristor est formée sur la face supérieure et l'autre électrode principale est formée sur la face inférieure. Dans l'exemple représenté, le substrat N1 correspond à une plaquette de silicium de type N. La face inférieure ou face arrière est munie d'une diffusion P2 de type P et, dans la face avant, est formée une région P3 de type P dans laquelle est diffusée une région N4 de type N. La métallisation de cathode K est solidaire de la région N4 et une métallisation de gâchette G est solidaire de la région P3. L'épaisseur restante du substrat N1 entre ses interfaces avec les régions P2 et P3 détermine notamment la tenue en tension du composant. On trouve aussi souvent dans ce type de structure verticale des murs d'isolement 3 et 4 respectivement formés à partir des faces supérieure et inférieure et se rejoignant pour délimiter une portion du substrat N1.

De nombreux types de composants de puissance verticaux sont connus, par exemple des thyristors, des triacs, des transistors de puissance, des transistors MOS de puissance et diverses variantes de ces composants à commande directe ou indirecte et éventuellement à commande en tension (commande par transistor MOS). De façon générale, tous ces composants se caractérisent par une structure verticale, dans l'épaisseur d'une plaquette, et le fait qu'une au moins des couches les constituant correspond à une portion épaisse du substrat peu dopé. Par ailleurs, ces dernières années, de nombreux progrès ont été réalisés dans les dopages de face arrière des plaquettes et on trouve maintenant diverses diffusions localisées du côté de la face arrière. Il est également connu qu'une portion de la face arrière peut être isolée de la métallisation de face arrière.

Dans certains cas, on souhaite aussi réaliser dans des dispositifs de puissance des composants latéraux.

La figure 2 représente un exemple d'un tel composant latéral à savoir un transistor PNP formé dans la face supérieure ou avant du substrat N1 et comprenant une région d'émetteur P5 de type P, une région de collecteur P6 de type P et une région de prise de contact de base N7 de type N. Comme pour un composant vertical, si l'on veut que la tenue en tension de ce composant soit élevée, il faut que la distance latérale entre les régions P5 et P6 soit importante, sensiblement égale à l'épaisseur verticale de la couche N1 considérée dans la figure 1.

La figure 3 représente un exemple de thyristor latéral formé dans la face supérieure du substrat N1 et comprenant une région d'anode P10 de type P, une région de gâchette de cathode P11 de type P et une région de cathode N12 de type N formée dans la région P11. Une région N13 a une fonction d'arrêt de canal. Ici encore, si l'on veut que la tenue en tension soit élevée, il faut que la distance latérale entre les régions P10 et P11 soit importante, sensiblement égale à l'épaisseur verticale de la couche N1 considérée dans la figure 1.

On cherche généralement à obtenir des transistors de gain relativement élevé et/ou des thyristors latéraux relativement sensibles, c'est-à-dire que les transistors qui les composent doivent présenter un gain relativement élevé. Ceci est a priori difficile étant donné la distance importante entre les régions P nécessaire à l'obtention d'une tenue en tension élevée. Pour augmenter le gain, on joue essentiellement sur le dopage des régions P5, P6, P10 et P11 et sur la profondeur de ces régions, ainsi que sur la topologie des diverses régions (structures en anneau ou digitées). Néanmoins, il est difficile d'arriver à des solutions satisfaisantes et, même si on y arrive, cela nécessite de réaliser certaines couches avec des niveaux ou des profils de dopage particuliers, ce qui fait que ces couches ne peuvent être réalisées en même temps que d'autres couches réalisées dans le même dispositif semiconducteur pour d'autres composants de ce dispositif.

Un autre composant latéral est illustré en figure 4A et correspond au montage en série de deux diodes telles que représentées en figure 4B formées du côté de la face avant d'un substrat N1. La première diode est formée par la jonction entre une région P20 de type P et une région N21 de type N formée dans cette région P20. Cette première diode comprend une métallisation A1 solidaire de la région N21 et une métallisation B1 solidaire de la région P20, avec généralement interposition d'une région de type P fortement dopée P22. De même, la deuxième diode comprend une région P24, une région N25 et une région P26 disposées de la façon représentée. La région N25 est solidaire de la même métallisation B1 que la région P22 et la région P26 est solidaire d'une métallisation C1.

Les figures 5A et 5B sont similaires aux figures 4A et 4B à la différence que, en figure 5A, le dispositif est construit sur un substrat de type P plutôt que sur un substrat de type N.

Un inconvénient des structures des figures 4A et 5A est qu'il existe un risque de déclenchement de thyristors parasites tels que le thyristor constitué par les régions N21-P20-N1-P24 ou d'autres thyristors parasites susceptibles d'exister entre diverses séries de diodes formées dans le même substrat, par exemple pour constituer un pont redresseur monolithique. Dans ce cas, contrairement à celui de la figure 3, on cherche à réduire autant que possible la sensibilité des thyristors parasites, c'est-à-dire le gain des transistors bipolaires qui les constituent. A nouveau, pour atteindre ce résultat, on joue essentiellement sur le niveau de dopage et le profil des régions P20 et P24. On utilise aussi des diffusions métalliques (or, platine) ou des irradiations électroniques ou protoniques, mais cela aussi complique le processus de fabrication ; de plus de tels traitements sont difficiles à localiser avec précision.

Tous les procédés connus d'ajustement de sensibilité ou de gain présentent, comme on l'a indiqué précédemment, d'une part, l'inconvénient de ne pas conduire de façon optimale au résultat souhaité, d'autre part, l'inconvénient de nécessiter des étapes de fabrication supplémentaires par rapport aux étapes standard de fabrication d'un dispositif semiconducteur de puissance.

Un objet de la présente invention est d'optimiser le gain ou la sensibilité de composants latéraux souhaités ou parasites pour pouvoir choisir un gain élevé dans le cas de composants souhaités et un gain faible dans le cas de composants parasites sans qu'il soit nécessaire de prévoir des étapes de fabrication autres que celles couramment utilisées pour la fabrication d'un dispositif semiconducteur de puissance.

Pour atteindre cet objet, la présente invention prévoit un dispositif semiconducteur monolitique décrit dans les revendications.

L'article de K.N. Bhat et M.K. Achuthan, IEEE TRANSACTIONS ON ELECTRON DEVICES, vol. 24, n° 3, mars 1977, PP. 205-214 décrit un mode de renforcement de gain dans des transistors P-N-P latéraux formés dans une couche épitaxiée, consistant à former une couche enterrée fortement dopée du même type que la couche épitaxiée sous cette couche épitaxiée.

Le brevet français 1 418 640 décrit des structures de thyristors latéraux formés dans une couche faiblement dopée de type N reposant sur une couche fortement dopée de type N.

La demande de brevet JP-A-52 15 0984 décrit un dispositif semiconducteur monolitique comprenant un transistor bipolaire latéral et un transistor bipolaire vertical.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 5 décrites précédemment sont destinées à illustrer le problème posé et l'état de la technique ; et
la figure 6 illustre le procédé selon la présente invention d'ajustement du gain ou de la sensibilité du composant latéral.

Conformément à l'usage dans le domaine de la représentation des composants semiconducteurs, les diverses vues en coupe ne sont pas tracées à l'échelle mais leurs dimensions horizontales et verticales sont arbitrairement dilatées ou rétrécies pour simplifier la représentation et améliorer la lisibilité.

La présente invention se base sur des expériences et des constatations effectuées par la demanderesse.

Alors que, quand on considère un composant latéral formé dans un dispositif de puissance, on s'intéresse comme on l'a montré en relation avec les figures 2 à 5, aux diffusions réalisées dans la face supérieure du composant en négligeant ce qui passe du côté de la face arrière puisque celle-ci est éloignée des diffusions de face avant par une épaisseur importante de substrat, la demanderesse a effectué une série d'expériences sur l'influence de diffusions de face arrière réalisées en regard du composant considéré.

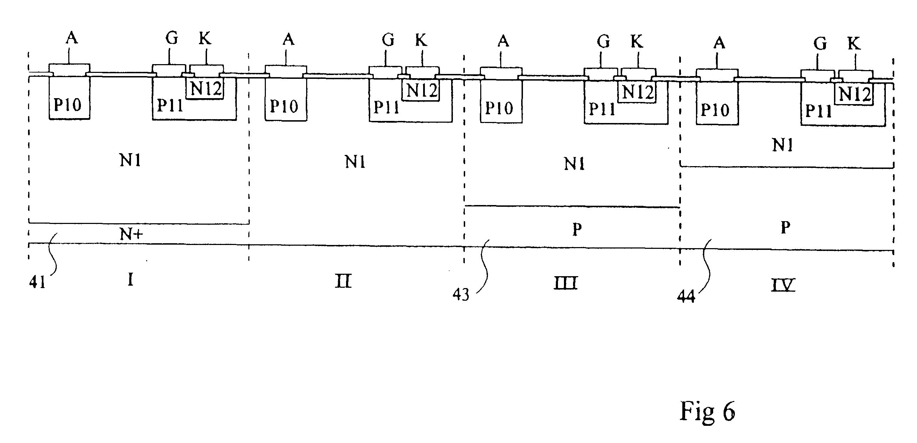

La figure 6 résume le résultat de ces observations dans le cas où le composant latéral considéré est un thyristor latéral. En figure 6, on a représenté un même thyristor latéral comprenant une région d'anode P10 de type P et une région de gâchette de cathode P11 de type P formées dans un substrat N1 de type N faiblement dopé, une région de cathode N12 de type N étant formée dans la région P11. La demanderesse a étudié la sensibilité de ce thyristor quand la face arrière du substrat comprenait une région 41 de type N fortement dopée (cas I), quand la face arrière ne comprenait aucune diffusion (cas II), quand la face arrière comprenait une région 43 de type P d'une profondeur correspondant sensiblement à celle des diffusions P formées à partir de la face supérieure (cas III), et quand la face arrière comprenait une région 44 de type P correspondant à la diffusion d'un mur d'isolement formé à partir de la face arrière (cas IV).

On s'aperçoit que la sensibilité des thyristors croît quand on passe du cas I au cas IV. On notera que, dans ce qui précède, on a considéré que la face arrière n'était pas polarisée à un niveau particulier. Elle est ou bien revêtue d'une couche isolante ou bien d'une métallisation mise à la masse.

De même le gain de transistors latéraux tels que celui de la figure 2 croît quand on passe du cas I au cas IV.

Bien que la demanderesse ne prétende pas donner une explication théorique du phénomène observé, on peut penser que ce phénomène est lié au comportement de la partie des charges émises par la région P10 (ou P5) vers le bas dans le substrat. Dans les cas I et II, ces charges se recombineraient dans la région de type N fortement dopée 41 ou au niveau de la face arrière, respectivement. Ces charges ne pourraient donc pas être collectées par la région P11 (ou P6). Par contre, dans les cas III et IV, la couche de type de conductivité opposé à celui du substrat aurait sur ces charges un effet miroir. Ces charges émises vers le bas seront donc finalement collectées par la région P11 (ou P6). Cette meilleure collection des charges entraîne une amélioration de gain (transistor) ou de sensibilité (thyristor). L'effet de recombinaison des charges serait amplifié quand une région 41 de même type que le substrat serait plus proche des diffusions de face supérieure et l'effet miroir se renforcerait quand une région 43 ou 44 de type opposé à celui du substrat serait plus proche des diffusions de face supérieure (ou serait plus fortement dopée).

On dispose ainsi d'un mode de réglage du gain d'un transistor latéral ou de la sensibilité d'un thyristor latéral par action sur les diffusions de face arrière d'un dispositif de puissance.

Plus particulièrement, pour avoir un thyristor latéral sensible ou très sensible, on choisira l'une des configurations selon le cas III ou IV. Pour éviter l'influence de thyristors latéraux parasites (cas des figures 4 et 5), on se placera dans le cas I ou II. Par exemple, dans le cas de la figure 4A, on réalisera en face arrière une diffusion de type N⁺ pour tuer le gain des thyristors latéraux et en figure 5A une diffusion de type P⁺.

Ceci pourra amener à modifier des structures existantes. Notamment, dans des structures incluant des thyristors verticaux tels que celui de la figure 1, où normalement toute la face arrière comporte une diffusion de type P, on interrompra cette diffusion de type P en regard de régions comportant des composants dans lesquels on veut éviter l'apparition de thyristors parasites tels que ceux des figures 4 et 5 et, de préférence, on réalisera une région de type P plus profonde en regard de composants du type de ceux des figures 2 et 3 dans lesquels on veut augmenter le gain ou la sensibilité.

En pratique, la mise en oeuvre de l'invention ne complique pas sensiblement les procédés usuels de fabrication de composants de puissance. Il conviendra seulement selon le résultat désiré de veiller à masquer ou à ne pas masquer des portions de la face arrière situées en regard de composants latéraux avant d'effectuer des opérations de diffusion dans la face avant de la plaquette.

La présente invention s'applique de façon générale au réglage du gain ou de la sensibilité de composants latéraux réalisés sur une face d'une plaquette semiconductrice. Ces composants latéraux peuvent être de tout type connu et comprendre les diverses variantes de réalisation connues. En ce qui concerne la réduction du gain ou de la sensibilité de composants parasites, on notera que ces composants parasites peuvent être non seulement des thyristors, mais aussi des transistors, des triacs...

La présente invention est susceptible de diverses variantes qui apparaîtront à l'homme de l'art. Notamment, dans chacun des exemples considérés, tous les types de conductivité pourront être intervertis.

## Revendications

1. Dispositif semiconducteur monolithique comprenant au moins un composant de puissance vertical formé dans un substrat (N1) faiblement dopé d'un premier type de conductivité et comprenant, du côté de la face arrière, une première région du deuxième type de conductivité (P2) opposé au premier type de conductivité, ce dispositif comprenant en outre un composant latéral formé dans la face avant du substrat, et comprenant, en regard du composant latéral, du côté de la face arrière, une deuxième région (43, 44) du deuxième type de conductivité,
le dispositif étant **caractérisé en ce que**
ladite deuxième région (43, 44) du deuxième type de conductivité est d'épaisseur supérieure à la première région susmentionnée du deuxième type de conductivité, d'où il résulte que le composant latéral est à gain élevé ou à forte sensibilité.

2. Dispositif semiconducteur monolithique selon la revendication 1, dans laquelle le composant vertical est du type thyristor ou triac.

3. Dispositif semiconducteur monolithique selon la revendication 1 ou 2, dans laquelle le composant latéral est du type thyristor ou transistor.

4. Dispositif semiconducteur monolithique selon la revendication 3, dans laquelle la deuxième couche du deuxième type de conductivité occupe sensiblement la moitié de l'épaisseur du substrat.

5. Dispositif semiconducteur monolithique comprenant au moins un composant de puissance vertical formé dans un substrat (N1) faiblement dopé d'un premier type de conductivité et comprenant, du côté de la face arrière, une première région du deuxième type de conductivité (P2) opposé au premier type de conductivité, ce dispositif comprenant en outre un composant latéral formé dans la face avant du substrat,
le dispositif étant **caractérisé en ce que** le composant latéral est un ensemble de diodes à jonction PN, et qu'il comprend, en regard desdites diodes, du côté de la face arrière, une troisième région (41) du premier type de conductivité à fort niveau de dopage.

6. Procédé de fabrication d'un dispositif semiconducteur selon la revendication 4, dans lequel la deuxième couche du deuxième type de conductivité est formée en même temps que des murs de diffusion latéraux formés à partir de la face arrière.

## Patentansprüche

1. Monolithische Halbleitereinrichtung mit wenigstens einer vertikalen Leistungskomponente, die in einem niedrig dotierten Substrat (N1) eines ersten Leitfähigkeitstyps ausgebildet ist und auf der Rückseite einen ersten Bereich des zweiten Leitfähigkeitstyps (P2), der dem ersten Leitfähigkeitstyp entgegengesetzt ist, aufweist, wobei diese Einrichtung ferner eine laterale Komponente aufweist, die in der Vorderseite des Substrats ausgebildet ist, und der lateralen Komponente gegenüberliegend auf der Rückseite einen zweiten Bereich (43, 44) des zweiten Leitfähigkeitstyps aufweist,
**dadurch gekennzeichnet, daß** der zweite Bereich (43, 44) des zweiten Leitfähigkeitstyps eine größere Dicke hat als der erste Bereich des zweiten Leitfähigkeitstyps, wobei die laterale Komponente einen hohen Verstärkungsfaktor oder eine hohe Empfindlichkeit aufweist.

2. Monolithische Halbleitereinrichtung nach Anspruch 1, wobei die vertikale Komponente eine Thyristor- oder eine Triac-Komponente ist.

3. Monolithische Halbleitereinrichtung nach Anspruch 1 oder 2, wobei die laterale Komponente eine Thyristor- oder Transistor-Komponente ist.

4. Monolithische Halbleitereinrichtung nach Anspruch 3, wobei die zweite Schicht des zweiten Leitfähigkeitstyps sich im wesentlichen über die Hälfte der Substratdicke erstreckt.

5. Monolithische Halbleitereinrichtung mit wenigstens einer vertikalen Leistungskomponente, die in einem niedrig dotierten Substrat (N1) eines ersten Leitfähigkeitstyps ausgebildet ist und auf der Rückseite einen ersten Bereich des zweiten Leitfähigkeitstyps (P2), der dem ersten Leitfähigkeitstyp entgegengesetzt ist, aufweist, wobei diese Einrichtung ferner eine laterale Komponente aufweist, die in der Vorderseite des Substrats ausgebildet ist, **dadurch gekennzeichnet, daß** die laterale Komponente einen Satz PN-Übergangs-Dioden umfaßt und daß sie diesen Dioden gegenüberliegend auf der Rückseite einen dritten Bereich (41) des zweiten Leitfähigkeitstyps mit einem hohen Dotierungspegel umfaßt.

6. Verfahren zum Herstellen einer Halbleitereinrichtung nach Anspruch 4, wobei die zweite Schicht des zweiten Leitfähigkeitstyps gleichzeitig mit den lateralen Diffusionswänden, welche von der Rückseite gebildet werden, gebildet wird.

## Claims

1. A monolithic semiconductor device comprising at least one vertical power component formed in a low doped substrate (N1) of a first conductivity type and comprising, on the back surface side, a first region of the second conductivity type (P2) opposed to the first conductivity type, this device further comprising a lateral component formed in the front surface of the substrate, and comprising, in front of the lateral component, on the back face side, a second region (43, 44) of the second conductivity type,
the device being **characterized in that** said second region (43, 44) of the second conductivity type has a greater thickness than said first region of the second conductivity type, whereby the lateral component has a high gain or a high sensitivity.

2. The monolithic semiconductor device of claim 1, wherein the vertical component is of the thyristor or triac type.

3. The monolithic semiconductor device of claim 1 or 2, wherein the lateral component is of the thyristor or transistor type.

4. The monolithic semiconductor device of claim 3, wherein the second layer of the second conductivity type extends substantially on the half of the substrate thickness.

5. A monolithic semiconductor device comprising at least one vertical power component formed in a low doped substrat (N1) of a first conductivity type and comprising, on the back surface side, a first region of the second conductivity type (P2) opposed to the first conductivity type, this device further comprising a lateral component formed in the front surface of the substrate, **characterized in that** the lateral component is a set of PN junction diodes, and **in that** it comprises, in front of said diodes, on the back surface side, a third region (41) of the first conductivity type with a high doping level.

6. A method of manufacturing a semiconductor device according to claim 4, wherein the second layer of the second conductivity type is formed simultaneously with the lateral diffusion walls formed from the back surface.
